# EUROPÄISCHE PATENTANMELDUNG

(11) **EP 2 461 137 A1**
(43) Veröffentlichungstag der Anmeldung: **06.06.2012**
(21) Anmeldenummer: 10015253.7
(22) Anmeldetag: 03.12.2010
(51) Int. Cl.: G01D 18/00, H03K 17/945

(54) **Sensor mit einem Teach-in-Schalter sowie Verfahren zum Einleiten eines Teach-in-Vorgangs**

(71) Anmelder: Baumer Innotec AG, 8500 Frauenfeld (CH)
(72) Erfinder: Brändle, Daniel, CH-8500 Frauenfeld (CH); Reetmeyer, Burkhard, DE-78465 Konstanz (DE); Hafner, Ueli, CH-8413 Neftenbach (CH)
(74) Vertreter: Strauss, Steffen

(57) **Zusammenfassung**

Die Erfindung betrifft einen Sensor mit einem Teach-In-Schalter, welcher als Hallsensor ausgebildet ist.

## Beschreibung

### Gebiet der Erfindung:

Die Erfindung betrifft einen Sensor mit einem Teach-in-Schalter sowie einer optischen Anzeige, um den eingeleiteten Teach-in-Modus sichtbar zu machen. Weiter betrifft die Erfindung ein Verfahren zum Einleiten eines Teach-in-Vorgangs.

### Hintergrund der Erfindung:

Es ist bekannt, Sensoren, insbesondere optische Sensoren, kapazitive und induktive Sensoren wie Näherungsschalter, Füllstandssensoren und Drehgeber nach dem Einbau anzulernen. Ein solcher Vorgang wird gemeinhin als Teach-in bezeichnet. Dabei wird beispielsweise ein Füllstandssensor in der Position "leer" und in der Position "voll" kalibriert, um sodann, sofern dieser als analoger Sensor ausgebildet ist, den Füllstand anzugeben, beziehungsweise, sofern der Sensor als Schwellwertschalter ausgebildet ist, bei vollem oder leerem Tank ein auswertbares Signal zu geben.

Aus der Praxis ist bekannt, den Teach-in-Vorgang über eine Schnittstelle, an welche der Sensor angeschlossen wird, einzuleiten. Dies hat den Vorteil, dass der Sensor über die Schnittstelle auch parametrierbar ist. Gleichzeitig ist aber zum einen hardwareseitig die Bereitstellung der Schnittstelle relativ aufwendig und in vielen Anwendungsfällen ist es auch aufwendig, dass der Sensor angeschlossen werden muss.

Es gibt weiter Sensoren, die nach Herstellung einer Stromversorgung zunächst automatisch in ein Teach-in-Modus schalten. Nachteilig hierbei ist, dass ein manuelles Einleiten des Teach-in-Modus nur durch Unterbrechung der Stromversorgung möglich ist. Weiterhin ist es kaum möglich, manuell in verschiedene Teach-in-Modi beispielsweise "voll" und "leer" zu schalten.

In der Praxis verbreitet sind daher Sensoren mit einem Teach-in-Schalter und einer optischen Anzeigeeinrichtung. Durch manuelles Drücken des Schalters kann der Sensor in einen Teach-in-Modus versetzt werden, der wiederum über eine optische Anzeigeeinrichtung, wie eine blinkende LED, angezeigt wird. Dieses System hat den Vorteil einer relativ einfachen Handhabung und über beispielsweise unterschiedlich lange Betätigungszeiten des Schalters kann der Sensor in verschiedene Teach-in-Modi versetzt werden, wobei diese beispielsweise über ein unterschiedliches Blinksignal auch vom Benutzer leicht unterschieden werden können.

Nachteilig ist aber, dass für einen derartigen Schalter zumeist anfällige mechanische Komponenten erforderlich sind, insbesondere muss bei Sensoren, welche hermetisch gekapselt sind, der Schalter abgedichtet werden. Dies kann beispielsweise mit einer Gummikappe erfolgen. Auch dies ist aufwendig und aufgrund des Alterungsprozesses von den verwendeten elastomeren Werkstoffen kann es zu Undichtigkeiten und damit zur Zerstörung des Sensors kommen.

### Aufgabe der Erfindung:

Der Erfindung liegt demgegenüber die Aufgabe zugrunde, die genannten Nachteile des Standes der Technik zumindest zu reduzieren.

Insbesondere ist es eine Aufgabe der Erfindung, einen Teach-in-Schalter bereit zu stellen, welcher ohne mechanische Komponenten auskommt und im Gehäuse des Sensors integriert werden kann, ohne dass ein gesondertes Fenster oder eine Kappe am Gehäuse erforderlich ist.

### Zusammenfassung der Erfindung:

Die Aufgabe der Erfindung wird bereits durch einen Sensor sowie durch ein Verfahren zum Einleiten eines Teach-in-Vorgangs nach einem der unabhängigen Ansprüche gelöst.

Bevorzugte Ausführungsformen und Weiterbildungen der Erfindung sind den jeweiligen Unteransprüchen zu entnehmen.

Die Erfindung betrifft einen Sensor.

Es handelt sich dabei insbesondere um einen optischen, ultraschall-, kapazitiven oder induktiven Sensor. Es kann sich des Weiteren sowohl um einen analogen Sensor als auch um einen Schwellwertschalter handeln. Beispielsweise kann die Erfindung optische Abstandssensoren, Näherungsschalter, Füllstandsgeber und Drehgeber betreffen.

Der Sensor umfasst ein Gehäuse mit einem in dem Gehäuse angeordneten Teach-in-Schalter und eine Anzeigeeinrichtung zur optischen Anzeige eines Betriebszustandes. Das Gehäuse kann beliebig ausgebildet sein. Unter einem Gehäuse wird auch eine Anordnung verstanden, bei welcher die Sensorkomponenten in einer Vergussmasse eingebettet sind, welche in diesem Fall das Gehäuse bildet.

Bei der optischen Anzeigeeinrichtung handelt es sich üblicherweise um eine LED, es versteht sich aber, dass auch andere Anzeigeeinrichtungen genutzt werden können.

Bei eingeleitetem Teach-In-Modus kann über die optische Anzeige, beispielsweise über eine Blinkfrequenz oder über eine bestimmte Lichtfarbe, insbesondere bei Verwendung verschiedenfarbiger LEDs angezeigt werden, dass der Sensor in einem Teach-In-Modus ist und/oder in welchem Teach-In-Modus sich der Sensor befindet. Über die optische Anzeige kann also ein Betriebszustand des Sensors angezeigt werden.

Gemäß der Erfindung ist als Teach-In-Schalter ein Hallsensor im Gehäuse angeordnet.

Die Erfinder haben herausgefunden, dass über einen Hallsensor eine besonders zuverlässige berührungslose Einleitung eines Teach-In-Vorgangs möglich ist. Weiter kann der Hallsensor mit Ausnahme von ferromagnetischen Werkstoffen hinter einem beliebigen Gehäusewerkstoff angeordnet sein, ohne dass hierfür ein Fenster erforderlich ist. Es ist insbesondere vorgesehen, das Gehäuse aus einem nicht ferromagnetischen Metall wie Aluminium oder einem Kunststoff auszubilden.

Je nach Ausgestaltung des Hallsensors kann mit einem magnetischen oder ferromagnetischen Handhabungswerkzeug durch bloße Annäherung der Teach-In-Vorgang eingeleitet werden. Hierfür eignet sich beispielsweise ein herkömmlicher Schraubendreher.

Bei einer bevorzugten Ausführungsform der Erfindung geht die Wirkrichtung des Sensors von einer unterschiedlichen Fläche des Sensorgehäuses aus wie die Wirkrichtung des Hallsensors. Zur Betätigung des Teach-In-Schalters kann sich dem Sensor so von einer anderen Richtung angenähert werden. Je nach Einbausituation ist es von Vorteil, wenn der Teach-In-Vorgang von der Seite oder von hinten eingeleitet wird. Weiter besteht auch nicht die Gefahr, durch das Handhabungswerkzeug, welches sich nach Einleiten des Teach-In-Vorgangs möglicherweise noch in Sensornähe befindet, ein Messfehler beim Anlernen verursacht wird.

Bei einer bevorzugten Ausführungsform der Erfindung ist das Gehäuse zumindest in einem dem Hallsensor zugewandten Bereich einteilig und geschlossen ausgebildet. Der Hallsensor befindet sich also hinter der Gehäusewand, welche zumindest im Bereich des Hallsensors nahtlos in das restliche Gehäuse übergeht, mithin kein Fenster oder ähnliches erforderlich ist. Das Gehäuse kann beispielsweise einen einteiligen zylinderförmigen Mantel umfassen. Auch eine topfförmige Ausgestaltung ist denkbar, bei welcher lediglich im Bereich der Wirkrichtung des Sensors ein Fenster angeordnet ist.

Vorzugsweise ist das Gehäuse starr und hermetisch verschlossen ausgebildet. Es kann somit auf eine Kappe aus elastomerem Material verzichtet werden, was zum einen die Herstellung vereinfacht und zum anderen die Haltbarkeit des Sensors verbessert.

Vorzugsweise unterscheidet sich die Wirkrichtung des Hallsensors von der Wirkrichtung des Sensors, insbesondere verläuft die Wirkrichtung des Hallsensors quer, insbesondere senkrecht zur Wirkrichtung des Sensors oder zeigt etwa in die entgegen gesetzte Richtung, so dass der Teach-In-Schalter von der Rückseite betätigt werden kann.

Bei einer Weiterbildung der Erfindung ist der Hallsensor als Schalter mit einem benachbart angeordneten Magneten ausgebildet. Durch Annäherung eines ferromagnetischen Handhabungswerkzeugs kommt es so zu einer Änderung der vom Magneten ausgehenden Feldlinien und somit zu einer Magnetfeldänderung, die über den Hallsensor erfasst werden kann. Die Verwendung eines Magneten als Handhabungswerkzeug ist damit nicht erforderlich.

Bei einer Ausführungsform des Sensors handelt es sich um einen Schwellwertschalter. Es ist aber auch denkbar, die Erfindung für analoge Sensoren zu verwenden.

Bei einer Weiterbildung der Erfindung ist der Hallsensor als SMD- (Surface Mounted Device) Bauteil auf einer Platine des Sensors angeordnet. So ist die Integration des Hallsensors als besonders einfache und kompakte Bauweise möglich und es ist beispielsweise möglich den Hallsensor bei der Herstellung der Platine direkt mit aufzulöten.

Die Erfindung betrifft des Weiteren ein Verfahren zum Einleiten eines Teach-In-Vorgangs bei einem Sensor, insbesondere bei einem vorstehend beschriebenen Sensor. Der Sensor weist einen Hallsensor auf, über welchen mittels Annäherung eines Handhabungswerkzeugs ein Teach-In-Vorgang ausgelöst wird. Hierzu kann beispielsweise ein ferromagnetisches Werkzeug, insbesondere ein Schraubendreher, verwendet werden.

Bei einer Ausführungsform der Erfindung können zumindest zwei verschiedene Teach-In-Zustände über die Dauer der Annäherung und/oder eine bestimmte Anzahl an Wiederholungen eingestellt werden.

So kann beispielsweise die Annäherung über eine bestimmte Zeitspanne unter einem Schwellwert einen ersten Modus, beispielsweise "Teach-In-leer", und eine längere Annäherung einen zweiten Modus, beispielsweise "Teach-In-voll", einleiten. Der jeweilige Modus wird sodann über die optische Anzeigeeinrichtung angezeigt, so dass der Benutzer eine unmittelbare Kontrolle hat, dass sich der Sensor im gewünschten Teach-In-Modus befindet. Gleiches ist auch über eine mehrmalige Annäherung innerhalb eines bestimmten Zeitfensters denkbar.

### Beschreibung der Zeichnungen:

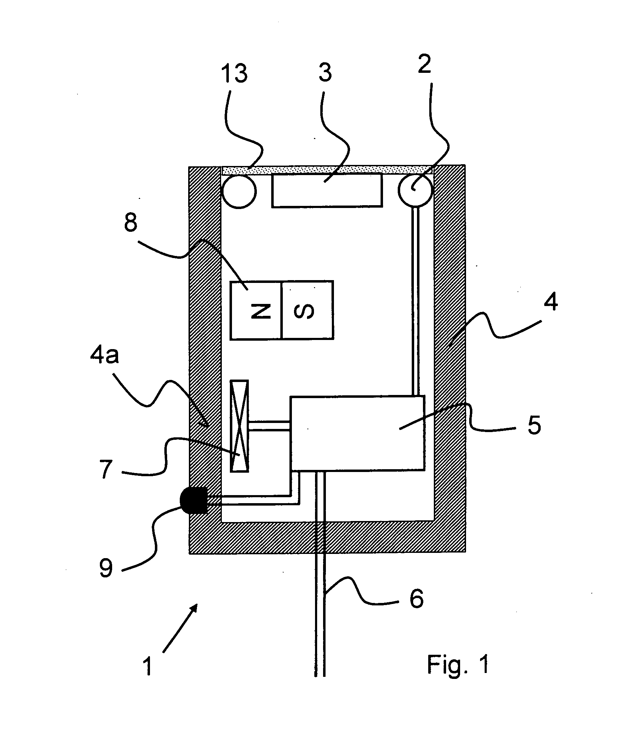

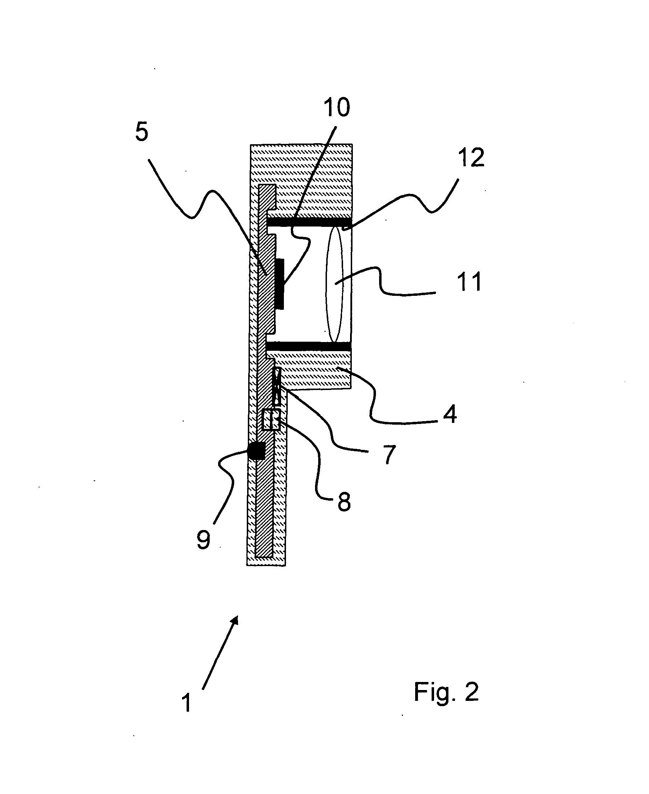

Die Erfindung soll im Folgenden Bezug nehmend auf schematisch dargestellte Ausführungsbeispiele gemäß den Zeichnungen Fig. 1 und Fig. 2 näher erläutert werden.

Fig. 1 zeigt ein erstes Ausführungsbeispiel eines Sensors 1. Es handelt sich hierbei um einen induktiven Sensor, bei dem einen Spule 2 um einen Ferritkern 3 gewickelt ist.

Die Spule 3 ist mit elektronischen Bauelementen auf einer Platine 5 verbunden, über die in einer dem Fachmann bekannten Weise ein Schwingkreis ausgebildet ist, der bei Annäherung verstimmt wird und so als Näherungsschalter wirksam ist. Die Spule 2 ist hinter einem Fenster 13 angeordnet, welches aus einem anderen Material besteht wie das restliche Gehäuse 4.

Das Gehäuse 4 ist in diesem Ausführungsbeispiel topfförmig ausgebildet und besteht aus einem nicht ferromagnetischen Material wie Kunststoff oder Aluminium.

Aufgrund der topfförmigen Ausgestaltung des Gehäuses 4 kann dies leicht hermetisch abgeschlossen sein, durch das topfförmige 4 Gehäuse verlaufen Anschlussleitungen 6 zum Anschluss der Sensorkomponenten, welche ebenfalls mit der Platine 5 verbunden sind.

Als Teach-In-Schalter umfasst der Sensor 1 einen Hallsensor 7, welcher ebenfalls mit der Platine 5 verbunden ist.

Der dem Hallsensor 7 gegenüberliegende Gehäuse Abschnitt 4a ist mit dem an den Hallsensor 7 angrenzenden Gehäuse 4 einteilig und einstückig ausgebildet. Mithin ist kein Fenster nötig.

Neben dem Hallsensor 7 befindet sich ein Permanentmagnet 8. Bei Annäherung eines ferromagnetischen Handhabungswerkzeugs (nicht dargestellt) laufen die Feldlinien des Magneten 8 zumindest teilweise in andere Richtungen, so dass sich das Magnetfeld gegenüber dem Hallsensor 7 ändert und ein Schaltsignal erzeugt werden kann.

Das Einleiten eines Teach-in-Modus wird über eine Anzeigeeinrichtung 9, insbesondere eine LED, welche ebenfalls über die Platine 5 verbunden ist, angezeigt. Über eine unterschiedliche Blinkfrequenz kann der jeweilige Teach-In-Modus angezeigt werden. Es ist aber auch denkbar, den jeweiligen Teach-In-Modus durch eine unterschiedliche Lichtfarbe anzuzeigen, insbesondere bei Verwendung einer RGB-LED.

Fig. 2 zeigt schematisch dargestellt eine alternative Ausführungsform eines Sensors 1.

Es handelt sich in diesem Fall um einen optischen Sensor, bei dem eine Fotodiode 10 hinter einer Linse 11 angeordnet ist. Um ein transparentes Fenster auszubilden, wird ein Linsenträger 12 verwendet, welcher auf eine Platine 5 aufgesetzt wird.

Ansonsten sind die Komponenten in diesem Ausführungsbeispiel mit einer Vergussmasse, insbesondere einem Harz vergossen, so dass das Gehäuse 4 nicht als Hohlkörper ausgebildet ist.

Auf der Platine 5 sind auch Hallsensor 7 und Permanentmagnet 8 angeordnet. Insbesondere kann für den Hallsensor 7 ein SMD-Bauteil verwendet werden. Ebenfalls auf der Platine 5 befindet sich eine optische Anzeigeeinrichtung 9 in Form einer LED.

Die Wirkrichtung des Hallsensors 7 liegt in diesem Ausführungsbeispiel der Wirkrichtung des optischen Sensors gegenüber, auch wenn der Hallsensor 7 auf derselben Platinenseite wie die Fotodiode 10 angeordnet ist. Dies hat den Vorteil, dass mit Ausnahme der optischen Anzeigeeinrichtung 9 sämtliche elektronischen Komponenten auf einer Platinenseite angeordnet sein können.

Bei einer alternativen Ausführungsform (nicht dargestellt) kann der Hallsensor 7 auch auf der der Fotodiode 10 gegenüberliegenden Seite angeordnet sein.

Durch die Erfindung konnte ein Sensor mit einem zuverlässigen Teach-In-Schalter bereit gestellt werden, bei dem auch auf ein gesondertes Fenster und bewegliche Bauteile verzichtet werden kann.

### Bezugszeichenliste:

- 1: Sensor
- 2: Spule
- 3: Ferritkern
- 4: Gehäuse
- 4a: Gehäuseabschnitt
- 5: Platine
- 6: Anschlussleitung
- 7: Hallsensor
- 8: Permanentmagnet
- 9: Anzeigeeinrichtung
- 10: Fotodiode
- 11: Linse
- 12: Linsenträger
- 13: Fenster

## Patentansprüche

1. Sensor, umfassend ein Gehäuse, ein in dem Gehäuse angeordeten Teach-In-Schalter sowie eine Anzeigeeinrichtung zur optischen Anzeige eines Betriebszustandes, insbesondere eines Teach-In-Betriebszustandes,
**dadurch gekennzeichnet, dass** als Teach-In-Schalter ein Hall-Sensor in dem Gehäuse angeordnet ist.

2. Sensor nach dem vorstehenden Anspruch, **dadurch gekennzeichnet, dass** es sich bei dem Sensor um einen optischen, Ultraschall-, kapazitiven oder induktiven Sensor handelt.

3. Sensor nach einem der vorstehenden Ansprüche, **dadurch gekennzeichnet, dass** die Wirkrichtung des Sensors von einer unterschiedlichen Fläche des Sensorgehäuses wie die Wirkrichtung des Hall-Sensors ausgeht.

4. Sensor nach einem der vorstehenden Ansprüche, **dadurch gekennzeichnet, dass** das Gehäuse zumindest in einem dem Hall-Sensor zugewandten Bereich einteilig und geschlossen ausgebildet ist.

5. Sensor nach einem der vorstehenden Ansprüche, **dadurch gekennzeichnet, dass** das Gehäuse starr und hermetisch verschlossen ausgebildet ist.

6. Sensor nach einem der vorstehenden Ansprüche, **dadurch gekennzeichnet, dass** sich das Gehäuse zumindest in einem dem Hall-Sensor zugewandten Bereich aus einem nicht ferromagnetischen Werkstoff, insbesondere einem Metall, besteht.

7. Sensor nach einem der vorstehenden Ansprüche, **dadurch gekennzeichnet, dass** sich die Wirkrichtung des Hall-Sensors von der Wirkrichtung des Sensors unterscheidet.

8. Sensor nach dem vorstehenden Anspruch, **dadurch gekennzeichnet, dass** sich die Wirkrichtung des Hall-Sensors quer, insbesondere senkrecht, zur Wirkrichtung des Sensors verläuft.

9. Sensor nach einem der vorstehenden Ansprüche, **dadurch gekennzeichnet, dass** der Hall-Sensor als Schalter mit einem benachbart angeordneten Magneten ausgebildet ist.

10. Sensor nach einem der vorstehenden Ansprüche, **dadurch**
**gekennzeichnet, dass** es sich um einen Schwellwertschalter handelt.

11. Sensor nach einem der vorstehenden Anspruche, **dadurch**
**gekennzeichnet, dass** der Hall-Sensor als SMD-Bauteil auf einer Platine des Sensors angeordnet ist.

12. Verfahren zum Einleiten eines Teach-In-Vorgangs bei
einem Sensor, insbesondere eines Sensors nach einem der vorstehenden Ansprüche, wobei der Sensor einen Hall-Sensor aufweist, über welchen mittels Annäherung eines Handhabungswerkzeugs ein Teach-In-Vorgang ausgelöst wird.

13. Verfahren zum Einleiten eines Teach-In-Vorgangs nach
dem vorstehenden Anspruch, **dadurch gekennzeichnet, dass** als Handhabungswerkzeug ein ferromagnetisches Werkzeug, insbesondere ein Schraubendreher, verwendet wird.

14. Verfahren zum Einleiten eines Teach-In-Vorgangs nach
einem der vorstehenden Ansprüche, **dadurch gekennzeichnet, dass** zumindest zwei verschiedene Teach-In-Zustände über die Dauer der Annäherung und/oder eine bestimmte Anzahl an Wiederholungen einer Annäherung eingestellt werden.

15. Verfahren zum Einleiten eines Teach-In-Vorgangs nach
dem vorstehenden Anspruch, **dadurch gekennzeichnet, dass** der Teach-In-Zustand über ein Lichtsignal einer Anzeigeeinrichtung optisch angezeigt wird.
